# EUROPEAN PATENT SPECIFICATION

(11) **EP 2 536 868 B1**
(45) Date of publication and mention of the grant of the patent: **13.12.2017**
(21) Application number: 11703008.0
(22) Date of filing: 15.02.2011
(51) Int. Cl.: C23C 16/455

(54) **HEATING SYSTEM FOR A VAPOR-PHASE DEPOSITION SOURCE**
HEIZSYSTEM FÜR EINE GASPHASENABSCHEIDUNGSQUELLE
SYSTÈME DE CHAUFFAGE POUR UNE SOURCE DE DÉPÔT EN PHASE VAPEUR

(30) Priority: 18.02.2010 US 305597 P; 16.02.2010 FR 1051098
(43) Date of publication of application: 26.12.2012
(73) Proprietor: Astron Fiamm Safety, 83077 Toulon (FR)
(72) Inventor: DUSSERT-VIDALET, Bruno, F-83130 La Garde (FR); GUERARD, Cédric, F-83400 Hyeres (FR)
(74) Representative: Decobert, Jean-Pascal
(86) International application number: PCT/EP2011/052172
(87) International publication number: WO 2011/101325

(56) References cited:
- EP-A1- 1 752 555
- EP-A1- 1 970 474
- US-B1- 6 453 992

## Description

### TECHNICAL FIELD OF THE INVENTION

The general field of the present invention concerns the vapor deposition of materials in the micro-electronics industry. More especially, it addresses the creation of vapor sources to enable continuous deposition on large surfaces that can be interrupted without inconvenience.

### STATE OF THE TECHNIQUE

The ever-increasing number of electronic and optical components and their integration within a same device has led to the development of sophisticated techniques for depositing various materials on a substrate to form the thin layers that constitute these devices.

Vapor-phase deposition covers a very broad range of processes, especially those described as vapor-phase chemical deposition, and generally designated by their English acronym of CVPD, "chemical vapor-phase deposition". As the name suggests, this type of deposition involves a chemical reaction occurring during the operation by, for instance, the prior introduction of a precursory gas into the deposition chamber or by a chemical reaction taking place with a layer of a material that has already been deposited on the substrate, and even with the substrate itself. Other types of chemical vapor-phase depositions do not involve such chemical reactions. These consist of simple physical deposition by evaporation in a controlled neutral atmosphere and/or in more or less vacuum conditions.

All the vapor-phase deposition techniques require a mechanical device in order to create in the deposition chamber the source of the evaporated material to be deposited. This is always a critical factor to be applied in order to obtain a uniform thickness of the thin layers deposited and good control over their physico-chemical characteristics. It is becoming increasingly difficult to create the source as the mass production, at low cost, of electronic and optical devices requires that the substrates on which they are applied are becoming increasingly large in size in order to produce an increasing number of devices, or increasingly large devices, during the same production cycle. Therefore, it is not surprising that there is a need for a source that allows continuous vapor-phase deposition of various materials over widths that may be measured in tens of centimeters, even around one meter. Moreover, the industrial production of such devices implies that deposition can be interrupted and restarted at will without damage to the source and the evaporated material.

Although the micro-electronics industry has for a long time been faced with the need to deposit materials such as dielectrics or metals, the manufacture of electroluminescent devices such as displays and screens containing organic electroluminescent diodes (OLEDs) requires recourse to the deposition of much more fragile organic materials.

Evaporation from a linear source of broad widths of organic material raises the critical problem of the temperature variation that has to be observed between the point of vapor creation and the points of its diffusion (i.e. nozzles installed over the full width of the source) in the deposition chamber. Indeed, to avoid the condensation of material on the walls of the tubes transporting the vapor and on those of the diffuser constituting the source, it is necessary to be able to maintain a constantly positive temperature gradient in order to prevent any cold zones lowering the temperature of the gas below its dewpoint. This is all the more difficult to carry out in that the destruction temperature of the material to be deposited is close to its evaporation temperature, for instance in the case of organic materials. It can be assumed that most of the materials decompose at temperatures above 450°C. Moreover, a difference between the evaporation temperatures and deterioration can be reached at around 10 to 100°C. These small differences limit the likelihood of evaporation taking place at a higher temperature. Moreover, very broad linear sources consisting of multiple volumes are more sensitive than point sources since this gradual temperature gradient has to be controlled over all the diffuser surface, from the evaporation crucible up to each nozzle.

Other problems made more difficult to resolve by this small difference between the evaporation and destruction temperatures have to be overcome. The heating system can itself create temperature irregularities at the surface of the evaporation crucible. These irregularities contribute to local deterioration of the material to be deposited, thereby reducing its use time and leading to losses, this material being generally extremely costly. It has to be said that there is a risk that a deteriorating material may lead to an unnoticed loss of the quality of the deposited film. There is therefore a notable risk of reduced production efficiency. This leads to other serious shortcomings in the context of industrial production such as the fact that a limited quantity of material has to be introduced between two depositions in order to reduce these losses. This is not easily made compatible with an uninterrupted online production process.

The linear sources are the subject of great interest, in particular for their capacity to achieve high speed deposition. They also ensure efficient use of the material mainly due to the source-substrate distance which is much smaller than with a point source. The presence of multiple nozzles and their design are intended to ensure uniform deposits over a large surface. This is a major advantage which makes their use essential for the large-scale production of devices such as the electroluminescent devices mentioned above. However, this short distance, combined with a high speed of evaporation, makes the conventional screen-type closing systems (which enable the process of deposition on the substrate to be interrupted) difficult to apply for mechanical reasons. The size of the conventional closing systems is incompatible with a long nozzle-type diffuser. In addition, they are not easy to use due to the speed with which they become clogged. There are also sources equipped with a valve enabling the vapor transport tube to be closed in order to interrupt its diffusion towards the substrate and not to waste the material to be evaporated. When closed, the valve then greatly reduce the volume of the pipe connected to the point at which the vapor is created. This significant reduction of the volume produces a sharp variation of the vapor generation system load and this increases the pressure in the vapor creation zone very significantly. This strong pressure variation then causes a rise in the temperature until saturation of the vapor creation zone. This rise in temperature will in turn cause thermal deterioration of the material to be deposited. EP1970474 A1 discloses a deposition source of a material in vapour phase comprising a vessel equipped with two zones: a vapour production zone equipped with a receptacle for the material and means for heating the material placed in the receptacle ;a chamber communicating with the production zone and equipped with at least one orifice so that the material in vapour phase is transmitted towards the exterior of the vessel through the orifice ;wherein the chamber comprises an inner wall and an outer envelope defining an intermediate space filled with a heat-transporting liquid for cooling the deposition source. Therefore, a general aim of the invention is to overcome at least in part one of the shortcomings described above found in the linear sources of vapor-phase deposition systems that are required to operate continuously with stopping and restarting deposition. It is also an aim of the invention to describe a linear source that enables the deposition of organic materials with a destruction temperature close to the evaporation temperature.

The other aims, characteristics and advantages of this invention will become clear on examination of the following description and the accompanying drawings. It is understood that other advantages may be incorporated.

### SUMMARY OF THE INVENTION

To achieve these aims, the invention describes a source for vapor-phase deposition of a material. This consists of a vessel divided into two zones. The first zone is for the production of vapor. It is equipped with a receptacle for the material and means for heating the material placed in the receptacle. The second is a diffusion zone comprising a vessel communicating with the production zone and equipped with at least one opening so that the vapor-phase material is transmitted towards the exterior of the vessel through the opening. The source is characterized in that, on the one hand, the room comprises an inner wall and an outer envelope defining an intermediate space filled with a heat-transporting liquid and, on the other, it is filled with means for heating this liquid.

The invention may also include the following options:
- means for heating the heat-transporting liquid include at least one electrical resistance entirely or partly in contact with the chamber outer envelope.
- the electrical resistance is in contact with the outer surface of the chamber outer envelope.
- the heating means comprise at least one electrical resistance positioned entirely or partly in the intermediate space.
- the electrical resistance is in contact with the outer surface of the inner wall.
- the means for heating the heat-transporting liquid includes a device for heating the heat-transporting liquid positioned outside the chamber and means for circulating the heat-transporting liquid between the heating device and the intermediate space.
- the thermal conductivity of the inner wall is greater than the thermal conductivity of the outer envelope.
- the receptacle has an inner wall and an outer envelope defining a second intermediate space filled with a heat-transporting liquid.
- the means for heating the receptacle include at least one electrical resistance entirely or partly in contact with the outer envelope of the receptacle.
- the receptacle heating means include at least one electrical resistance positioned entirely or partly in the second intermediate space.
- the receptacle heating means include a device for heating the heat-transporting liquid situated outside the receptacle and means for circulating the heat-transporting liquid between the heating device and the second intermediate space.
- the thermal conductivity of the receptacle wall is greater than the thermal conductivity of the receptacle outer envelope.
- the receptacle includes one or several fins on its inner surface in contact with the material.
- at least one orifice equipped with a nozzle passing through the intermediate space.
- the intermediate space surrounds all the outer surface of the inner wall of the chamber.
- the vapor production zone and the chamber connect at a right angle.
- the vapor production zone is centered on the width of the chamber.
- heating means are located at the level of at least one orifice.
- for each orifice, the heating means comprise a filament around the peripheral wall of the orifice.
- the filament is positioned on the outside of the intermediate space.
- the filament is positioned in the intermediate space.

### BRIEF DESCRIPTION OF THE FIGURES

The aims, purposes, characteristics and advantages of the invention will be better understood from the detailed description of its embodiment shown on the following accompanying drawings on which:
Figures 1A and 1B show a linear vapor-phase deposition source according to the invention in which the heating filaments are wrapped around the outer envelope of the heating furnace and the vapor diffuser containing a heat-transporting fluid.
Figures 2A and 2B show a variant of the linear vapor-phase deposition source according to the invention in which the heating filaments are in direct contact with the heat-transporting fluid.

The attached drawings are given as examples and are not restrictive.

### DETAILED DESCRIPTION OF THE INVENTION

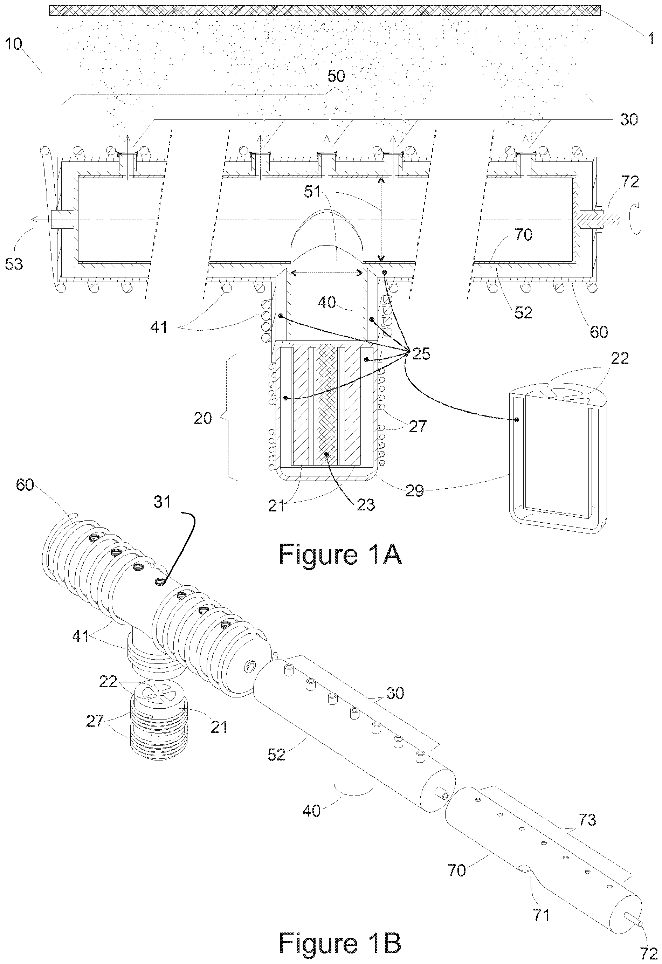

**Figures 1A and 1B** show a linear vapor-phase deposition source according to the invention in which the heating filaments are wrapped around the outer envelope of the heating furnace and the vapor diffuser.

The invention describes how, in a preferred embodiment, a linear vapor-phase deposition source 10 makes it possible to obtain a very gradual temperature gradient between the heating furnace or material production zone 20 and the evaporation nozzles forming orifices 30 of a chamber 50.

A deposition source of the same type as the invention comprising a vapor production zone at the level of which the material is transformed into a vapor phase by the application of heat.

The source comprises a production zone for the said vapor capable of bringing the vapor via orifices 30 outside the source so that the material can be deposited.

The source includes a chamber performing the diffusion, that is to say distributing steam from production zone 20.

The connection between production zone 20 and chamber 50 takes place in the examples shown via a pipe 40, in the continuity of receptacle 21 of material 23 to be evaporated. Advantageously, pipe 40 is an integral part of chamber 50 forming a "T" between the two source zones.

The adjective linear is taken to mean a source with several nozzles (a preferred embodiment), the nozzles being juxtapositioned according to one dimension of the source. Preferably, this juxtaposition comprises an alignment of the nozzles along a straight line, but this is not a restrictive arrangement.

Crucible or receptacle 21 of the furnace contains material 23 to be evaporated, for instance an organic material of the type used to manufacture electroluminescent diodes. It bathes in a heat-transporting fluid 25 which is present all around the crucible in an intermediate space, hereafter called the second intermediate space (relative to an intermediate space also formed at the level of chamber 50 and described further on), between the two coaxial tubes forming the heating furnace, i.e. the crucible itself and outer envelope 29 of the furnace. This tubular configuration is advantageous but not restrictive. The second intermediate space is generally formed between an inner wall of receptacle 21 receiving material 23, and an envelope 29.

Advantageously, the second intermediate space covers a part of the base and the lateral wall of receptacle 21, the part of the latter opposite the base connecting with chamber 50. In the example of the embodiment of the invention shown in figures 1A and 1B, the heating means consist of filaments 27 around the outer envelope of the heating furnace. Therefore, receptacle 21 is not in direct contact with the heating filaments. This avoids the creation of hot points with the inconveniences mentioned in the introduction concerning the state of the technique, that is to say the material to be evaporated has a shorter use life, with deterioration and loss of a costly material. Therefore, heating of the crucible is indirect. This takes place via the heat-transporting fluid which ensures a generally uniform evaporation temperature.

Like receptacle 21, the chamber bathes in a heat-transporting liquid 25 present in all the annular space and arranged between on the one hand pipe 40 and inner wall 52 of the diffuser, and on the other an outer tubular envelope 60 in the form of a T, the branches of which are coaxial with pipe 40 and transversal part of chamber 50 respectively.

The heat-transporting liquid has to be capable of transferring the heat within a range of temperatures that is compatible with the evaporation temperature of the materials. The main constraint on the choices of the liquid to be used is its chemical stability in relation to the temperature so that its physical-chemical properties remain unrelated to the temperature buildup. For the organic materials more especially considered here, a fluid has to be capable of operating typically up to 400°C. The liquids may have different chemical compositions: silicon-based, synthetic aromatic compounds or based on the use of synthetic products. Moreover, it is preferable that they have a small coefficient of thermal expansion in order to guarantee a constant volume of liquid and a high heat transfer coefficient so as to optimize the quantity of heat transmitted to the inner wall of the source. Fluids that meets these criteria are available from trade sources. For example:
- Therminol 75® produced by the company SOlutia Europe SPRL/BVBA 3 Rue Laid Burniat, B-1348 Louvain la Neuve (Sud), Belgium,
- Syltherm 800® produced by the company 'Dow Chemical' whose registered office and sales offices in France are: 'Dow France S.A.S', Avenue Jules Rimet, 93631 La Plaine St Denis.

In this embodiment of the invention, heating filaments 41 also surround the outer tubular envelope in order to indirectly heat the diffuser by using a heat-transporting liquid which thereby ensures excellent distribution of the heat over all the surfaces in contact with on the one hand the material to be evaporated in the heating furnace and with the vapor in the chamber with injection pipe 40 and horizontal diffuser on the other.

Moreover, the figures show optional heating means located at the level of orifices 30. In the embodiment shown on figures 1A and 1B, this local means of heating include filaments 31 positioned at the upper end of orifices 30, that is to say at the nozzle outlet of the pipes. Filaments 31 marry the distal peripheral wall of the pipes outside the intermediate space.

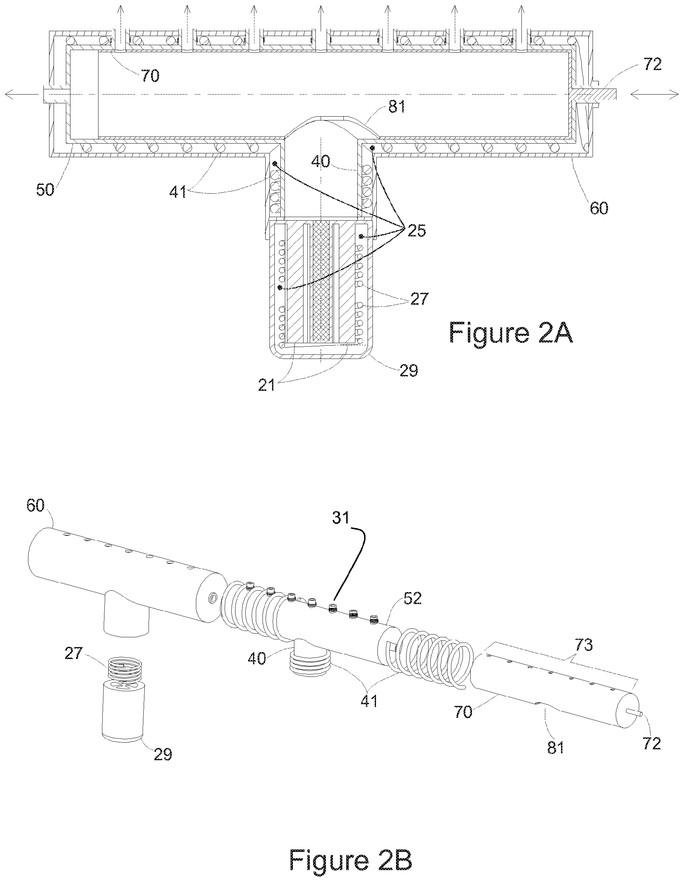

As an option, figures 2A and 2B show filaments 31 around the pipes of orifices 30, inside the intermediate space.

In ring form, filaments 31 ensure even finer adjustment of the temperature gradient.

This heating means used in combination with an embodiment of receptacle 21 and its envelope 20, as well as vertical pipe 40, body of chamber 50 and their envelope 60, in material(s) having a good thermal conduction (metal for example) guarantee very even temperature all along the walls in contact with material to be evaporated or its vapor. This eliminates the hot points that could develop if filaments are in direct contact with these walls.

In order to guarantee an even temperature up to the core of the material to be evaporated placed in the crucible or receptacle 21, the latter comprises radial fins 22. These greatly increase the heating surface between the crucible and the load and diffuse by conduction all the heating power in order to avoid any temperature differences inside it. This avoids the material in contact with the walls charring locally whereas the material at the center of the crucible would be at a lower temperature if this did not take place.

The slight temperature gradient, but nevertheless still positive, that has to be advantageously created from the vapor source to the nozzles to ensure that the deposition source functions properly while not exceeding the destruction temperature of the material to be deposited, can therefore be ensured by exercising electrical control of the heating filaments and their distribution over all the diffuser, the vertical injection pipe and the crucible. The presence of the heat-transporting liquid very effectively smoothes out any variations and prevents the appearance of hot spots.

In one embodiment, the different controls of the filaments or resistance 27 and 41 facilitate this adjustment. Therefore, resistances 27 and 41 can be divided into several bodies controlled differently in order to adjust the heating, depending on the position of the source.

Lastly, for the linear source of the invention to be used for continuous industrial production, means have also to be provided for stopping and restarting the process of evaporation without damaging the materials to be evaporated. This aim of the invention is achieved in this first embodiment of the invention by placing a vapor check valve in the diffuser. This check valve takes the form of a rotary sleeve 70 with a diameter that corresponds to the inner diameter of the diffuser and which can be turned using an axial mechanical control 72. Orifices 73 are drilled at the position of the nozzles so that the steam can pass through during deposition operations. Simple rotation of the sleeve is sufficient to mask the nozzles and interrupt the deposition process. Lower orifice 71, which is positioned opposite vertical vapor injection pipe 40, is such that when rotated to mask the nozzles, the latter do not obstruct the steam injection pipe 40.

Figures **2A and 2B** show a variant of the linear vapor-phase deposition source according to the invention in which the heating or electrical resistance filaments are in direct contact with the heat-transporting liquid.

This figure shows that it is possible to place the heating elements in the annular spaces containing the heat-transporting liquid 25. Immersed in the heat-transporting liquid, the filaments apply heat directly, thereby ensuring that the temperatures are at least as uniform as in the previous case. This concerns both filaments 27, that are used to heat receptacle 21, and filaments 41 that are used to maintain the temperature gradient around vertical pipe 40 and inner wall 52. In this case, the outer walls are much cooler and this limits the radiation of heat from the linear source in the deposition chamber containing the deposition source. In this second embodiment of the invention, the outer envelope of crucible 29 and that of diffuser 60 can be advantageously executed in a material with low thermal conductivity in order to further reduce this radiation. As an alternative, a liquid coolant system such as water may limit this radiation.

Therefore, it will be noted that heating of the heat-transporting liquid can be offset to a buffer tank positioned outside the deposition chamber (not shown). The liquid, which is then circulating at the level of the source and/or the chamber, can be changed during use, enabling for instance, rapid cooling of the source and, in general, the temperature to be controlled from an external device. In this case, there is no need to install the heating filaments.

In this second implementation of the invention, rotary sleeve 70 is replaced by sliding sleeve 70. A little shorter than the diffuser forming the transversal body of chamber 50, the nozzles are closed this time by lateral movement of sliding sleeve 70 using axial control 72. As previously, openings 73 are drilled at the position of the nozzles in order to allow the vapor to pass through during the deposition phase. Lower orifice 81, which is positioned opposite vertical vapor injection pipe 40, has a shape and dimensions such that the lateral displacement in order to mask the nozzles does not obstruct vapor pipe 40 in any way.

Of course, the embodiment options illustrated on figures 1, 2 can be combined without any inconvenience. Filaments may be placed in the heat-transporting liquid and this may be associated with the use of a rotary sleeve. The opposite is also possible (sliding sleeve and heating elements around the envelopes).

The heating means thus described can also be combined.

Similarly, liquid 25 may or may not be identical in the two intermediate spaces. The spaces can communicate to render the temperatures uniform, or be separated.

The valve can also be interlocked and used to ensure an emitted flux regulation guaranteeing a rapid change of flux or stability of flux without temperature variations. In particular, this solution quickly smoothes out any flux variations that depend on the level of the material filling the crucible.

It will be noted that the intermediate space also surrounds the diffusion nozzles. The steam is thus heated up to the last end of the deposition source.

## Claims

1. Deposition source of a material in vapor phase (10) comprising a vessel equipped with two zones:
a vapor production zone (20) equipped with a receptacle for the material and means for heating the material placed in the receptacle (21) ;
a chamber (50) communicating with the production zone and equipped with at least one orifice (30) so that the material in vapor phase is transmitted towards the exterior of the vessel through the orifice (30) ;
wherein the chamber (50) comprises an inner wall (52) and an outer envelope (60) defining an intermediate space filled with a heat-transporting liquid (25) and the deposition source is equipped with means for heating the heat-transporting liquid (25)
**characterized in that**, the means for heating the heat-transporting liquid (25) includes a device for heating the heat-transporting liquid (25) positioned outside the chamber (50) and means for circulating the heat-transporting liquid (25) between the heating device and the intermediate space.

2. Deposition source according to claim 1 wherein the means for heating of heat-transporting liquid (25) include at least one electrical resistance (41) entirely or partly in contact with the outer envelope (60) of the chamber (50).

3. Deposition source according to claim 2 wherein the electrical resistance (41) is in contact with the outer surface of the outer envelope (60) of the chamber (50).

4. Deposition source according to any of claims 1, 2, or 3 wherein the heating means of heat-transporting liquid (25) include at least one electrical resistance (41) placed entirely or partly in the intermediate space.

5. Deposition source according to the previous claim wherein the electrical resistance (41) is in contact with the outer surface of the inner wall (52).

6. Deposition source according to any of the preceding claims wherein the thermal conductivity of the inner wall (52) is greater than the thermal conductivity of the outer envelope (60).

7. Deposition source according to any one of the aforesaid claims wherein the receptacle (21) includes an inner wall and an outer envelope (29) defining a second intermediate space filled with a heat-transporting liquid (25).

8. Deposition source according to the previous claim wherein the means for heating the material placed in the receptacle (21) include at least one electrical resistance (27) entirely or partly in contact with the outer envelope (29) of the receptacle (21).

9. Deposition source according to one of claims 7 or 8 wherein the means for heating the material placed in the receptacle (21) include at least one electrical resistance (27) positioned entirely or partly in the second intermediate space.

10. Deposition source according to one of claims 7 to 9 wherein the means for heating the material placed in the receptacle (21) include a device for heating the heat-transporting liquid (25) positioned outside the receptacle (21) and means for circulating the heat-transporting liquid (25) between the heating device and the second intermediate space.

11. Deposition source according to one of claims 9 or 10 wherein the thermal conductivity of the inner wall of receptacle (21) is greater than the thermal conductivity of the outer envelope (29) of receptacle (21).

12. Deposition source according to any one of the previous claims wherein the receptacle (21) includes one or several fins (22) on its inner surface in contact with the material.

13. Deposition source according to any one of the previous claims wherein the at least one orifice (30) has a nozzle that traverses the intermediate space.

14. Deposition source according to any one of the previous claims wherein the intermediate space surrounds all the outer surface of the inner wall (52) of the chamber (50).

15. Deposition source according to any one of the above claims wherein the vapor production zone (20) and the chamber (50) are connected at a right angle.

16. Deposition source according to the previous claim wherein the vapor production zone (20) is centered on the width of the chamber (50)

17. Deposition source according to any one of the previous claims comprising local heating means located at the level of at least one orifice (30).

18. Deposition source according to the previous claim wherein the local heating means include, for each orifice (30), a filament (31) around the peripheral wall of the orifice (30).

19. Deposition source according to the previous claim wherein the filament (31) is situated on the outside of the intermediate space.

20. Deposition source according to claim 18 wherein the filament (31) is situated in the intermediate space.

## Patentansprüche

1. Abscheidungsquelle eines Materials in Gasphase (10), umfassend einen Reaktor, der mit zwei Zonen ausgestattet ist:
- einer Gaserzeugungszone (20), die mit einem Gefäß für das Material und Mitteln zum Erhitzen des Materials, das sich in dem Gefäß (21) befindet, ausgestattet ist;
- einer Kammer (50), die mit der Erzeugungszone verbunden und mit mindestens einer Öffnung (30) ausgestattet ist, so dass das Material in Gasphase durch die Öffnung (30) zur Außenseite des Reaktors geleitet wird;
- wobei die Kammer (50) eine Innenwand (52) und eine Außenhülle (60) umfasst, die einen Zwischenraum definieren, der mit einer wärmetransportierenden Flüssigkeit (25) gefüllt ist, und die Abscheidungsquelle mit Mitteln zum Erhitzen der wärmetransportierenden Flüssigkeit (25) ausgestattet ist,
**dadurch gekennzeichnet, dass** die Mittel zum Erhitzen der wärmetransportierenden Flüssigkeit (25) eine Vorrichtung zum Erhitzen der wärmetransportierenden Flüssigkeit (25) umfassen, die außerhalb der Kammer (50) angeordnet ist, und Mittel für den Umlauf der wärmetransportierenden Flüssigkeit (25) zwischen der Heizvorrichtung und dem Zwischenraum.

2. Abscheidungsquelle nach Anspruch 1, wobei die Mittel zum Erhitzen der wärmetransportierenden Flüssigkeit (25) mindestens einen elektrischen Widerstand (41) umfassen, der vollständig oder teilweise mit der Außenhülle (60) der Kammer (50) in Kontakt ist.

3. Abscheidungsquelle nach Anspruch 2, wobei der elektrische Widerstand (41) mit der Außenfläche der Außenhülle (60) der Kammer (50) in Kontakt ist.

4. Abscheidungsquelle nach einem der Ansprüche 1, 2 oder 3, wobei die Heizmittel der wärmetransportierenden Flüssigkeit (25) mindestens einen elektrischen Widerstand (41) umfassen, der vollständig oder teilweise in dem Zwischenraum angeordnet ist.

5. Abscheidungsquelle nach dem vorhergehenden Anspruch, wobei der elektrische Widerstand (41) mit der Außenfläche der Innenwand (52) in Kontakt ist.

6. Abscheidungsquelle nach einem der vorhergehenden Ansprüche, wobei die Wärmeleitfähigkeit der Innenwand (52) größer ist als die Wärmeleitfähigkeit der Außenhülle (60).

7. Abscheidungsquelle nach einem der vorhergehenden Ansprüche, wobei das Gefäß (21) eine Innenwand und eine Außenhülle (29) umfasst, die einen zweiten Zwischenraum definieren, der mit einer wärmetransportierenden Flüssigkeit (25) gefüllt ist.

8. Abscheidungsquelle nach dem vorhergehenden Anspruch, wobei die Mittel zum Erhitzen des Materials, das in dem Gefäß (21) angeordnet ist, mindestens einen elektrischen Widerstand (27) umfassen, der vollständig oder teilweise mit der Außenhülle (29) des Gefäßes (21) in Kontakt ist.

9. Abscheidungsquelle nach einem der Ansprüche 7 oder 8, wobei die Mittel zum Erhitzen des Materials, das in dem Gefäß (21) angeordnet ist, mindestens einen elektrischen Widerstand (27) umfassen, der vollständig oder teilweise in dem zweiten Zwischenraum angeordnet ist.

10. Abscheidungsquelle nach einem der Ansprüche 7 bis 9, wobei die Mittel zum Erhitzen des Materials, das in dem Gefäß (21) angeordnet ist, eine Vorrichtung zum Erhitzen der wärmetransportierenden Flüssigkeit (25) umfassen, die außerhalb des Gefäßes (21) angeordnet ist, und Mittel für den Umlauf der wärmetransportierenden Flüssigkeit (25) zwischen der Heizvorrichtung und dem zweiten Zwischenraum.

11. Abscheidungsquelle nach einem der Ansprüche 9 oder 10, wobei die Wärmeleitfähigkeit der Innenwand des Gefäßes (21) größer ist als die Wärmeleitfähigkeit der Außenhülle (29) des Gefäßes (21).

12. Abscheidungsquelle nach einem der vorhergehenden Ansprüche, wobei das Gefäß (21) eine oder mehrere Lamellen (22) auf seiner Innenfläche umfasst, die mit dem Material in Kontakt sind.

13. Abscheidungsquelle nach einem der vorhergehenden Ansprüche, wobei die mindestens eine Öffnung (30) eine Düse aufweist, die den Zwischenraum durchsetzt.

14. Abscheidungsquelle nach einem der vorhergehenden Ansprüche, wobei der Zwischenraum die ganze Außenfläche der Innenwand (52) der Kammer (50) umgibt.

15. Abscheidungsquelle nach einem der vorhergehenden Ansprüche, wobei die Gaserzeugungszone (20) und die Kammer (50) in einem rechten Winkel verbunden sind.

16. Abscheidungsquelle nach dem vorhergehenden Anspruch, wobei die Gaserzeugungszone (20) mittig an der Breite der Kammer (50) angeordnet ist.

17. Abscheidungsquelle nach einem der vorhergehenden Ansprüche, umfassend lokale Heizmittel, die auf Höhe von mindestens einer Öffnung (30) angeordnet sind.

18. Abscheidungsquelle nach dem vorhergehenden Anspruch, wobei die lokalen Heizmittel für jede Öffnung (30) einen Heizfaden (31) rund um die umlaufende Wand der Öffnung (30) umfassen.

19. Abscheidungsquelle nach dem vorhergehenden Anspruch, wobei sich der Heizfaden (31) auf der Außenseite des Zwischenraums befindet.

20. Abscheidungsquelle nach Anspruch 18, wobei sich der Heizfaden (31) in dem Zwischenraum befindet.

## Revendications

1. Source de dépôt d'un matériau en phase vapeur (10) comprenant une cuve équipée de deux zones :
une zone de production de vapeur (20) équipée d'un réceptacle pour le matériau et d'un moyen de chauffage du matériau placé dans le réceptacle (21) ;
une chambre (50) communiquant avec la zone de production et équipée d'au moins un orifice (30) pour que le matériau en phase vapeur soit transmis vers l'extérieur de la cuve à travers l'orifice (30) ;
dans laquelle la chambre (50) comprend une paroi interne (52) et une enveloppe externe (60) définissant un espace intermédiaire rempli d'un liquide transporteur de chaleur (25) et la source de dépôt est équipée d'un moyen de chauffage du liquide transporteur de chaleur (25)
**caractérisée en ce que**, le moyen de chauffage du liquide transporteur de chaleur (25) inclut un dispositif de chauffage du liquide transporteur de chaleur (25) positionné à l'extérieur de la chambre (50) et un moyen de circulation du liquide transporteur de chaleur (25) entre le dispositif de chauffage et l'espace intermédiaire.

2. Source de dépôt selon la revendication 1, dans laquelle le moyen de chauffage du liquide transporteur de chaleur (25) inclut au moins une résistance électrique (41) entièrement ou en partie en contact avec l'enveloppe externe (60) de la chambre (50).

3. Source de dépôt selon la revendication 2, dans laquelle la résistance électrique (41) est en contact avec la surface externe de l'enveloppe externe (60) de la chambre (50).

4. Source de dépôt selon l'une quelconque des revendications 1, 2 ou 3, dans laquelle le moyen de chauffage de liquide transporteur de chaleur (25) inclut au moins une résistance électrique (41) placée entièrement ou en partie dans l'espace intermédiaire.

5. Source de dépôt selon la revendication précédente, dans laquelle la résistance électrique (41) est en contact avec la surface externe de la paroi interne (52).

6. Source de dépôt selon l'une quelconque des revendications précédentes, dans laquelle la conductivité thermique de la paroi interne (52) est plus grande que la conductivité thermique de l'enveloppe externe (60).

7. Source de dépôt selon l'une quelconque des revendications précédentes, dans laquelle le réceptacle (21) inclut une paroi interne et une enveloppe externe (29) définissant un second espace intermédiaire rempli d'un liquide transporteur de chaleur (25).

8. Source de dépôt selon la revendication précédente, dans laquelle le moyen de chauffage du matériau placé dans le réceptacle (21) inclut au moins une résistance électrique (27) entièrement ou en partie en contact avec l'enveloppe externe (29) du réceptacle (21).

9. Source de dépôt selon l'une des revendications 7 ou 8, dans laquelle le moyen de chauffage du matériau placé dans le réceptacle (21) inclut au moins une résistance électrique (27) positionnée entièrement ou en partie dans le second espace intermédiaire.

10. Source de dépôt selon l'une des revendications 7 à 9, dans laquelle le moyen de chauffage du matériau placé dans le réceptacle (21) inclut un dispositif de chauffage du liquide transporteur de chaleur (25) positionné à l'extérieur du réceptacle (21) et un moyen de circulation du liquide transporteur de chaleur (25) entre le dispositif de chauffage et le second espace intermédiaire.

11. Source de dépôt selon l'une des revendications 9 ou 10, dans laquelle la conductivité thermique de la paroi interne du réceptacle (21) est plus grande que la conductivité thermique de l'enveloppe externe (29) du réceptacle (21).

12. Source de dépôt selon l'une quelconque des revendications précédentes, dans laquelle le réceptacle (21) inclut une ou plusieurs ailettes (22) sur une surface interne en contact avec le matériau.

13. Source de dépôt selon l'une quelconque des revendications précédentes, dans laquelle au moins un orifice (30) comporte une buse qui traverse l'espace intermédiaire.

14. Source de dépôt selon l'une quelconque des revendications précédentes, dans laquelle l'espace intermédiaire entoure toute la surface externe de la paroi interne (52) de la chambre (50).

15. Source de dépôt selon l'une quelconque des revendications précédentes, dans laquelle la zone de production de vapeur (20) et la chambre (50) sont raccordées à angle droit.

16. Source de dépôt selon l'une quelconque des revendications précédentes, dans laquelle la zone de production de vapeur (20) est centrée sur la largeur de la chambre (50).

17. Source de dépôt selon l'une quelconque des revendications précédentes, comprenant un moyen de chauffage local situé au niveau d'au moins un orifice (30).

18. Source de dépôt selon la revendication précédente, dans laquelle le moyen de chauffage local inclut, pour chaque orifice (30), un filament (31) autour de la paroi périphérique de l'orifice (30).

19. Source de dépôt selon la revendication précédente, dans laquelle le filament (31) est situé sur l'extérieur de l'espace intermédiaire.

20. Source de dépôt selon la revendication 18, dans laquelle le filament (31) est situé dans l'espace intermédiaire.
